# EUROPÄISCHE PATENTSCHRIFT

(11) **EP 0 897 611 B1**
(45) Veröffentlichungstag und Bekanntmachung des Hinweises auf die Patenterteilung: **22.03.2000**
(21) Anmeldenummer: 97922868.1
(22) Anmeldetag: 25.04.1997
(51) Int. Cl.: H03H 9/64

(54) **MINDESTENS ZWEI FILTERZWEIGE ENTHALTENDES KOMMUNIKATIONSSYSTEM**
COMMUNICATION SYSTEM COMPRISING AT LEAST TWO FILTER BRANCHES
SYSTEME DE COMMUNICATION CONTENANT AU MOINS DEUX BRANCHES DE FILTRAGE

(30) Priorität: 09.05.1996 DE 19618706
(43) Veröffentlichungstag der Anmeldung: 24.02.1999
(73) Patentinhaber: SIEMENS MATSUSHITA COMPONENTS GmbH & CO. KG, 81541 München (DE)
(72) Erfinder: BAUREGGER, Josef, D-81737 München (DE)
(74) Vertreter: Zedlitz, Peter
(86) Internationale Anmeldenummer: DE9700843
(87) Internationale Veröffentlichungsnummer: WO9743827

(56) Entgegenhaltungen:
- EP-A- 0 678 973
- PATENT ABSTRACTS OF JAPAN vol. 010, no. 340 (E-455), 18.November 1986 & JP 61 142812 A (TOSHIBA CORP), 30.Juni 1986,
- JEE JOURNAL OF ELECTRONIC ENGINEERING, Bd. 32, Nr. 339, 1.März 1995, Seiten 39-44, XP000500042 SHIHOKI S: "DEMAND FOR MOBILE COMMUNICATIONS EQUIPMENT PROPELS PRODUCTION WORLDWIDE"

## Beschreibung

Die vorliegende Erfindung betrifft ein Kommunikationssystem mit wenigstens zwei jeweils ein mit akustischen Oberflächenwellen arbeitendes Filter - OFW-Filter - enthaltenden Filterzweigen.

Kommunikationssysteme der in Rede stehenden Art können so ausgebildet sein, daß ein Empfangssignal bestimmter Frequenz mittels eines Mischers auf eine vorgegebene Zwischenfrequenz umgesetzt wird. Dabei wird der Mischer von einem Signal mit ebenfalls vorgesehener Frequenz von einem lokalen Oszillator angesteuert. Bei diesem Konzept muß sowohl das Empfangssignal als auch das Signal vom lokalen Oszillator vor der Mischung gefiltert werden.

Das Dokument, EP-A-678,973 offenbart ein Kommunikationssystem mit einem mit akustischen Oberflächenwellen arbeitenden Filter. Das Filter wird mit einem SAW Resonator auf einem gemeinsamen piezoelektrischen Substrat gefertigt.

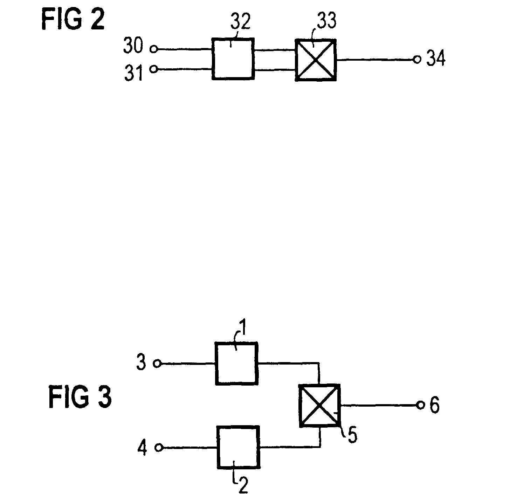

Ein Prinzipblockschaltbild eines derartigen Kommunikationssystems mit zwei Filterzweigen ist in Figur 3 dargestellt. Dabei wird an einem Eingang 3 ein Empfangssignal in ein Filter 1 und an einem Eingang 4 ein Signal von einem lokalen Oszillator in ein Filter 2 eingespeist. Die Ausgangssignale der beiden Filter 1 und 2 werden in einen Mischer 5 eingespeist, an dessen Ausgang 6 ein Zwischenfrequenzsignal abnehmbar ist.

Figur 4 zeigt in schematischer Darstellung ein OFW-Filter, das als Filter 1 bzw. 2 nach Figur 3 verwendbar ist. Bei diesem Filter ist auf einem piezoelektrischen Substrat 10 eine elektro-akustische Filterstruktur 11 vorgesehen. Das durch das piezoelektrische Substrat 10 und die elektro-akustische Struktur 11 gebildete Filter ist in einem Gehäuse 12 angeordnet. Mittels Kontaktierungsdrähten 16 ist von der elektro-akustischen Struktur 11 eine Verbindung zu einem Signaleingang 13, einem Signalausgang 14 sowie Masseanschlüssen 15 realisiert.

Handelt es sich bei dem Kommunikationssystem der in Rede stehenden Art um ein Mobiltelefonsystem, so ist in schnurlosen tragbaren Telefonapparaten der zur Verfügung stehende Platz für die notwendigen Schaltungskomponenten des Systems begrenzt.

Der vorliegenden Erfindung liegt daher die Aufgabe zugrunde, Filter mit geringem Platzbedarf für Kommunikationssysteme zu schaffen.

Dieser Aufgabe wird bei einem Kommunikationssystem der eingangs genannten Art erfindungsgemäß durch die Maßnahmen des kennzeichnenden Teils des Patentanspruchs 1 gelöst.

Eine Weiterbildung der Erfindung ist Gegenstand von Unteransprüchen.

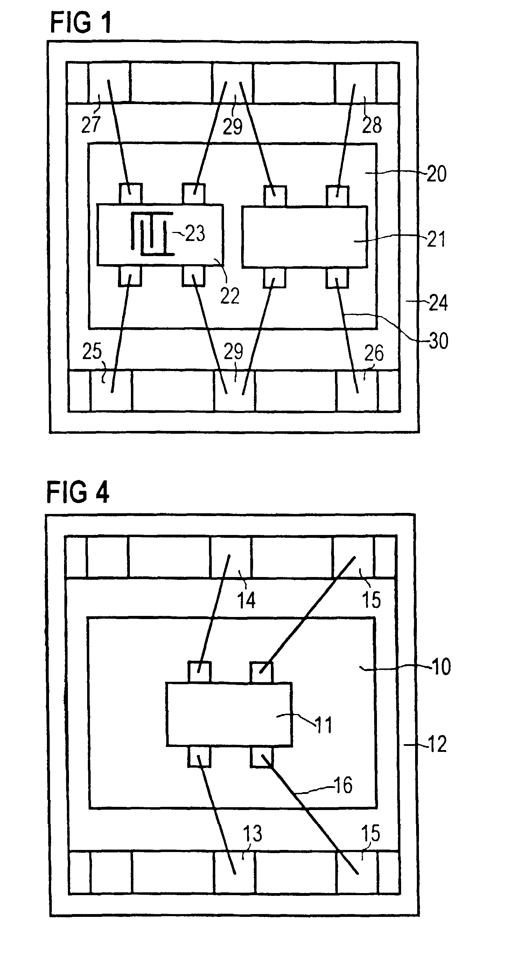

Die Erfindung wird nachfolgend anhand eines Ausführungsbeispiels gemäß den Figuren 1 und 2 der Zeichnung näher erläutert. Die Figuren 1 und 2 zeigen dabei den oben erläuterten Darstellungen nach den Figuren 3 und 4 entsprechende Darstellungen.

Gemäß Figur 1 sind auf einem piezoelektrischen Substrat 20 zwei OFW-Filter 21 und 22 vorgesehen, wobei im Filter 22 eine elektro-akustische Filterstruktur in Form einer Interdigitalstruktur 23 schematisch angedeutet ist. Das durch das piezoelektrische Substrat 20 sowie die Filter 21 und 22 gebildete Mehrfachfilter ist in einem einzigen Gehäuse 24 angeordnet. Über Kontaktierungsdrähte 30 sind elektrische Verbindungen zu Signaleingängen 25, 26, Signalausgängen 27, 28 sowie zu Masseanschlüssen 29 realisiert.

Ein schematisches Blockschaltbild für ein Kommunikationssystem mit einem Mehrfachfilter nach Figur 1 ist in Figur 2 mit einem Empfangssignaleingang 30, einem Eingang 31 für ein Signal von einem lokalen Oszillator, einem zu einer Baueinheit vereinigten Filter 32 für die beiden Signale, einem Mischer 33 sowie einem Ausgang 34 für ein Zwischenfrequenzsignal dargestellt.

Die Vereinigung bzw. Integration von Filtern auf einem einzigen Substrat in einem einzigen Gehäuse ist nicht auf zwei Filterstrukturen gemäß Figur 1 beschränkt. Müssen mehrere Signale unterschiedlicher Frequenzlage gefiltert werden, so lassen sich die verschiedenen OFW-Filterstrukturen auf einem einzigen Substrat in einem einzigen Gehäuse realisieren. Die Anzahl der Filterstrukturen ist also nicht auf zwei beschränkt.

## Patentansprüche

1. Kommunikationssystem mit wenigstens zwei jeweils ein mit akustischen Oberflächenwellen arbeitendes Filter - OFW-Filter - enthaltenden Filterzweigen,
**dadurch gekennzeichnet**,
daß elektro-akustische Strukturen (23) der Filter (21, 22) auf einem gemeinsamen piezoelektrischen Substrat (20) vorgesehen sind.

2. Kommunikationssystem nach Anspruch 1,
**dadurch gekennzeichnet**,
daß das die elektro-akustischen Strukturen aufweisende Substrat (20) in einem einzigen Gehäuse (24) angeordnet ist.

3. Schaltungsanordnung des Kommunikationssystems nach Anspruch 1 oder 2,
**dadurch gekennzeichnet,**
daß ein Empfangssignaleingang (30) und ein Eingang (31) für ein Signal von einem lokalen Oszillator vorgesehen sind, daß die beiden Signale einem zu einer Baueinheit vereinigten Filter (32) zugeführt werden und daß ein Mischer (33) vorgesehen ist, an dessen Ausgang (34) ein Zwischenfrequenzsignal vorliegt.

4. Verwendung einer Schaltungsanordnung nach Anspruch 3 in einem Mobilfunkgerät.

## Claims

1. Communications system with at least two filter branches, each containing a filter operating with surface acoustic waves - SAW filter, characterized in that the electro-acoustic structures (23) of the filters (21, 22) are provided on a common piezoelectric substrate (20).

2. Communications system according to Claim 1, characterized in that the substrate (20) comprising the electro-acoustic structures is arranged in a single housing (24).

3. Circuit arrangement for a communications system according to Claim 1 or 2, characterized in that a reception-signal input (30) and an input (31) for a signal from a local oscillator are provided, in that the two signals are fed to a filter (32) combined to form a module, and in that a mixer (33) is provided, at whose output (34) there is an intermediate-frequency signal.

4. Use of a circuit arrangement according to Claim 3 in a mobile radio.

## Revendications

1. Système de communication comprenant au moins deux branches de filtrage contenant à chaque fois un filtre fonctionnant avec des ondes acoustiques de surface - filtre à ondes acoustiques de surface -, caractérisé en ce que des structures électro-acoustiques (23) des filtres (21, 22) sont prévues sur un substrat piézo-électrique (20) commun.

2. Système de communication selon la revendication 1, caractérisé en ce que le substrat (20) pourvu des structures électro-acoustiques est situé dans un boîtier unique (24).

3. Circuit du système de communication selon l'une des revendications 1 ou 2, caractérisé en ce qu'une entrée de signal de réception (30) et une entrée (31) pour un signal d'un oscillateur local sont prévues, en ce que les deux signaux sont amenés à un filtre (32) combiné à un module et en ce qu'un mélangeur (33) est prévu, à la sortie (34) duquel un signal de fréquence intermédiaire est présent.

4. Utilisation d'un circuit selon la revendication 3 dans un appareil radio mobile.
